# EUROPÄISCHE PATENTANMELDUNG

(11) **EP 2 133 539 A2**
(43) Veröffentlichungstag der Anmeldung: **16.12.2009**
(21) Anmeldenummer: 09007518.5
(22) Anmeldetag: 08.06.2009
(51) Int. Cl.: F02D 9/10, F16K 27/02, B29C 45/14

(54) **Drosselklappenstutzen mit Drosselklappe**

(30) Priorität: 11.06.2008 DE 102008027888; 24.01.2009 DE 202009000926 U
(71) Anmelder: Apel, Helga, 59394 Nordkirchen (DE)
(72) Erfinder: Apel, Helga, 59394 Nordkirchen (DE)
(74) Vertreter: Hoffmeister, Helmut

(57) **Zusammenfassung**

Die Erfindung betrifft eine Drosselklappenvorrichtung, bestehend aus wenigstens einem Drosselklappenstutzen (1, 2, 3), einer Drosselklappe (4) und einer Drosselklappenwelle (5), mit der die Drosselklappe (4) verstellbar im Drosselklappenstutzen (1, 2, 3) angeordnet ist.

Damit deren Teile störungsfreier funktionieren können und sich günstiger herstellen lassen, besteht der Drosselklappenstutzen aus einem Innenzylinder (1) aus einem harten, glatten, Werkstoff, um den wenigstens teilweise ein Außenzylinder (2) aus einem Thermoplasten geformt ist.

## Beschreibung

Die Erfindung betrifft eine Drosselklappenvorrichtung, bestehend aus wenigstens einem Drosselklappenstutzen, einer Drosselklappe und einer Drosselklappenwelle, mit der die Drosselklappe verstellbar im Drosselklappenstutzen angeordnet ist, und Verfahren zu deren Herstellung.

Eine Drosselklappenvorrichtung der eingangs genannten Art ist aus der DE 195 49 509 A1 bekannt. Sie besteht aus einem Gehäuse und einer Drosselklappe. Die Drosselklappe ist mit einer Drosselklappenwelle verstellbar im Drosselklappengehäuse angeordnet und regelt den Luftdurchsatz zu einem Fahrzeugmotor.

Nachteilig ist, dass das Gehäuse und die Drosselklappe aus Aluminium bestehen und nachbearbeitet werden müssen. Bei der Nachbearbeitung ist auf eine hohe Passgenauigkeit zu achten. Hierdurch entsteht ein hoher Kostenaufwand. Nachteilig ist weiterhin, dass sich die Drosselklappe im Drosselklappengehäuse festfressen kann. Bei niedrigen Temperaturen besteht außerdem die Gefahr, dass die Drosselklappe festfrieren kann.

Aus der EP 11 54 240 A2 ist eine Drehstellergebervorrichtung bekannt, bei der eine Sensoreinheit durch ein Stanzgitterelement mit wenigstens einer Gitterschiene an eine Ausgangseinheit angeschlossen ist. Nachteilig ist, dass die Bauelemente mit der die Sensoreinrichtung zu beschalten ist, einzeln auf das Stanzgitterelement aufgebracht werden müssen.

Aus der DE 10 2006 030 133 A1 ist eine Moduleinheit bekannt, die ein Leitungsgitter und einen Flächenbereich umfasst, auf dem eine Prägeplatte (Die) angeordnet ist. Auf den Leitungssträngen sind Bauelemente angeordnet. Ein Isolierkörper ist so ausgebildet, dass mehrere Leitungsstränge und das Die eingebettet sind. Ein weiterer Isolierkörper kapselt die Bauelemente ein.

Ein teilweise zweischichtiger Körper für einen Drosselklappenstutzen ist aus der EP 1 554 099 bekannt.

Es stellt sich die Aufgabe, eine Drosselklappenvorrichtung der eingangs genannten Art so weiter zu entwickeln, dass deren Teile störungsfreier funktionieren können und sich günstiger herstellen lassen.

Erfindungsgemäß wird diese Aufgabe dadurch gelöst, dass der Drosselklappenstutzen aus einem Innenzylinder aus einem harten, glatten, Werkstoff besteht, um den wenigstens teilweise ein Außenzylinder aus einem Thermoplasten geformt ist.

Der Werkstoff kann ein nicht-metallischer Werkstoff sein. Ausgewählt kann hier aus Duroplasten oder keramischen Werkstoffen werden.

Der Werkstoff kann ein metallischer Werkstoff sein. Ausgewählt werden kann dann ein gezogenes Aluminium, Magensium oder ein fließgepreßtes Material.

Die hiermit bestehenden Vorteile bestehen insbesondere darin, dass ein Nacharbeiten wie bei gegossenen Werkstoffen nicht erforderlich ist. Die Herstellungskosten sinken damit drastisch, während in gleichem Maße die Passgenauigkeit zunimmt.

Vorzugsweise besteht der Drosselklappenstutzen aus einem Innenzylinder aus Duroplast oder Keramik, um den wenigstens teilweise ein Außenzylinder aus Thermoplast geformt ist, wobei die Drosselklappe aus einem Duroplast-Mittelkörperelement besteht, der wenigstens teilweise von einem Thermoplast-Einfassungsköper umgeben ist.

Die Lösungen haben insbesondere gemeinsam, dass die Hauptbestandteile der Drosselklappenvorrichtung als tragendes Element einen stabilen Körper haben, der aus einem Duroplast oder aus Keramik besteht. Duroplaste bzw. Keramiken sind unempfindlich gegenüber Treibstoffgemischen. Ein wesentlicher Vorteil besteht darin, dass praktisch keine Nachbearbeitung mehr erforderlich ist. Derartige Zylinderelemente können auch als Präzisionsrohre gezogen sein.

Kommt insbesondere ein Duroplast zum Einsatz, weisen die Körper, die aus diesem Material hergestellt sind, eine ausreichend hohe Temperaturbeständigkeit und eine kleine ThermoSchrumpfung auf. Darüber hinaus erfolgt eine äußerst geringe Feuchtigkeitsaufnahme, und für die Formung ist ein geringer Spritzdruck erforderlich. Um sie insbesondere gegenüber harten Schlägen schützen zu können, umhüllt diese Körper ein Außenzylinder aus einem elastischem Thermoplast.

Das Material der Drosselklappe kann einen Duroplast-Mittelkörperelement umfassen, das allseitig bzw. wenigstens teilweise von einem Thermoplast-Einfassungsköper umgeben werden kann.

Der Innenzylinder kann wenigstens teilweise mit einem Abflachungsabschnitt versehen sein. Der Abflachungsabschnitt verhindert insbesondere ein Verdrehen des Innenzylinders im Außenzylinder.

Der Innenzylinder kann wenigstens teilweise von einem Rippenabschnitt umgeben sein. Hierdurch wird ein Verschieben im Außenzylinder vermieden.

Der Innenzylinder kann wenigstens teilweise mit einer Innenbeschichtung versehen sein. Diese Innenbeschichtung kann wenigstens im Bereich des Drosselklappen-Kontaktes teilweise aus PTFE (Handelname Teflon) bestehen. Hierdurch wird ein Festfressen der Drosselklappe wirksam vermieden.

Die Drosselklappenwelle kann wenigstens ein Rastelement aufweisen, durch das die Drosselklappenwelle mit der Drosselklappe verbunden werden kann. Die Rastelemente sorgen dafür, dass eine Verstellkraft, die von einem Stellmotor ausgehen kann, auch zu einem Verstellen der Drosselklappe führt. Ein Verdrehen der Drosselklappenwelle nur in der Drosselklappe wird so vermieden. Als Rastelement kommt ein Rastkörper infrage. Rastelemente können aber auch als Zahnelemente ausgebildet sein.

Auf dem Mittelköperelement der Drosselklappe kann ein Thermoplast-Innenkörper als Thermoplast-Einfassungsköper angeordnet sein. Es ist auch möglich, auf dem Mittelkörperelement der Drosselklappe - dem Thermoplast-Innenkörper gegenüberliegend - kann ein Thermoplast-Außenzylinder angeordnet sein. Der Mittelkörper ist damit wie von einem Belag eines Sandwichs eingefasst.

Die Drosselklappenwelle kann in Gleit- und/oder Kugellagern gelagert werden. Hierbei ist es möglich, dass das Drosselklappenwelle in
- zwei sich gegenüberliegenden Gleitlagern,
- zwei sich gegenüberliegenden Kugellagern,
- einem Gleitlager und einem gegenüberliegenden Kugellager, gelagert wird.

An den Außenzylinder aus Thermoplast kann ein Gehäuseunterteil angeformt werden. Im Gehäuseunterteil kann eine Mess- und Verstelleinrichtung angeordnet sein, bei der eine Sensoreinheit und eine Ausgangseinheit durch ein Verbindungsgitterelement verbunden sind, das wenigstens eine Gitterschiene aufweisen kann.

Die Sensoreinheit kann eine Moduleinheit aufweisen, bei der eine integrierte Schaltung auf einem Flächenbereich einer leitenden Platte angeordnet und durch einen Spritzkörper gekapselt sein kann. Über Leitungsstränge kann die integrierte Schaltung mit Bauelementen verbunden werden kann, die durch einen weiteren Spritzkörper gekapselt sein kann. Das Verbinden kann durch Bonddrähte oder durch Schweißen erfolgen.

Die Sensoreinheit kann eine Doppelmoduleinheit aufweisen, bei der eine leitfähige Platte einen oberen und unteren Flächenbereich aufweisen kann,
- wobei auf dem oberen Flächenbereich eine erste integrierte Schaltung angeordnet und durch einen ersten Spritzkörper gekapselt sein kann,
- wobei über erste Leitungsstränge die erste integrierte Schaltung mit ersten Bauelementen verbunden sein kann, die durch einen zweiten Spritzkörper gekapselt sein können,
- wobei auf dem unteren Flächenbereich eine zweite integrierte Schaltung angeordnet sein kann, die durch einen dritten Spritzkörper gekapselt sein kann, und
- wobei über zweite Leitungsstränge die zweite integrierte Schaltung mit zweiten Bauelementen verbunden sein kann, die durch einen vierten Spritzkörper gekapselt werden können.

Das Verbinden kann auch hier durch Bonden oder Schweißen erfolgen.

Sowohl die Modul- als auch die Doppelmoduleinheit gewährleisten, dass die integrierte Schaltung des Sensors bereits entsprechend vorbeschaltet werden kann. Der Vorteil besteht insbesondere darin, dass die Vorbeschaltung am Band vorgenommen wird und hierdurch Fertigungskosten in hohem Maße eingespart werden können. Bei fast gleichem Platzbedarf für zwei integrierte Schaltungen wird darüber hinaus bei der Doppelmoduleinheit eine Schiene eingespart.

Der Innenzylinder kann längs und/oder quer geteilt werden. Hierbei kann er in eine linke und rechte Hälfte aufweisen. Der Innenzylinder kann auch in einen oberen und einen unteren Drosselklappenstutzen-Teil geteilt werden. Die Teilung kann im Bereich der Drosselklappenwelle vorgenommen werden.
Bei einer Querteilung liegt dieser Bereich in Höhe der Drosselklappenwelle, bei einer Querteilung in Längsflucht der Drosselklappenwelle, sodaß in beiden Fällen die Drosselklappenwelle samt Lagern und dgl. vollständig montiert zwischen beide Hälften gelegt werden.

Die Gleit- und/oder Kugellager können wenigstens teilweise durch Lagereinfassungsbereiche des Außenzylinders aus Thermoplast eingefasst werden.

Die Teilung des Innenzylinders des Drosselklappenstutzens vereinfacht die Montage der Drosselklappenwelle mit seiner Lagerung, denn die Lager brauchen nur in die entsprechend vorgesehenen Lagerausnehmungen eingelegt, beide Innenzylinderteile zusammen mit einem Thermoplastzylinder umspritzt werden und dann durch die Lagereinfassungsbereiche mit Hilfe der Lagereinfassungsbereiche festgelegt und abgedichtet werden. Die Erfindung bezieht sich außerdem auf ein Verfahren zur Herstellung einer Drosselklappenvorrichtung, umfassend folgende Verfahrensschritte:
a) Formen eines oberen und unteren Teil-Innenzylinders aus einem harten, glatten, Werkstoff mit wenigstens einem Abflachungsabschnitt und wenigstens einem Rippenelement;
b) Aufstecken von Gleit- und/ oder Kugellagern auf die Drosselklappenwelle;
c) Aufsetzen des oberen und des unteren Teil-Innenzylinders und Einfassen der Gleit- und/oder Kugellager durch beide Teil-Innenzylinder;
d) Umspritzen des oberen und unteren Teil-Innenzylinder durch einen Außenzylinder aus Thermoplast und wenigstens teilweises Einfassen der Gleit- und/ oder Kugellager durch Lagereinfassungsbereiche.

Die Erfindung bezieht sich weiterhin auf ein Verfahren zur Herstellung einer Drosselklappenvorrichtung, gekennzeichnet durch eine Verwendung von Duroplast derart, dass
a) dass zwei Teil-Innenzylinder aus aus Duroplast mit wenigstens einem Abflachungsabschnitt und wenigstens einem Rippenelement geformt werden,
b) dass Gleit- und/oder Kugellager auf die Drosselklappenwelle aufgesteckt werden,
c) dass die beiden Teil-Innenzylinder zusammen gesetzt und die Gleit- und/oder Kugellager der zwischen ihnen eingesetzten Drosselklappenwelle durch beide Teil-Innenzylinder eingefasst werden,
d) dass die beiden Teil-Innenzylinder durch einen Außenzylinder aus Thermoplast umspritzt und die Gleit- und/oder Kugellager durch Lagereinfassungsbereiche wenigstens teilweises eingefasst werden.

Die Verwendung von Duroplast führt zu einer vollkommen neuen Herstellungsart der Drosselklappenvorrichtung. Beide Halbschalen erhalten ihre endgültige Form ohne große Nachbearbeitung. Zwischen sie kann die Drosselklappenwelle mit ihrer Lagerung eingesetzt werden. Ein umständliches "Einfädeln" erübrigt sich. Der Außenmantel aus Thermoplast hält dann letztendlich alles zusammen. Der Fertigungsaufwand gegenüber Drosselklappenvorrichtungen aus Alumium-Guss reduziert sich auf ca. 30 %.

Vor allem der Außenmantel sorgt für einen dichten Zylinderkörper, in dem sich die Drosselklappe bewegen kann.

Beim Formen des Außenzylinderhohlkörpers kann gleich ein Gehäuseunterteil mit angeformt werden.
Äußerlich sieht damit die Drosselklappenvorrichtung wie die herhömmlichen aus und erzielt dadurch beim Hersteller und Verbraucher Vertrauen und Akzeptanz.

Die Erfindung wird nachstehend anhand der Zeichnung näher erläutert. Es zeigen
Fig. 1 eine Drosselklappenvorrichtung in einer schematischen, perspektivischen Darstellung,
Fig. 2 einen Drosselklappenstutzen einer Drosselklappenvorrichtung in einer schematischen Schnittdarstellung entlang der Linie II-II gemäß Figur 1,
Fig. 3 einen Drosselklappenstutzen einer Drosselklappenvorrichtung in einer schematischen Schnittdarstellung entlang der Linie III-III gemäß Figur 1,
Fig. 4 einen Ausschnitt X aus einem Drosselklappenstutzen gemäß Fig. 3 in einer vergrößerten schematischen Schnittdarstellung,
Fig. 5 eine Drosselklappe einer Drosselklappenvorrichtung gemäß Fig. 1 in einer vergrößerten, geschnittenen, schematischen Darstellung,
Fig. 6 eine Drosselklappenwelle einer Drosselklappenvorrichtung gemäß Fig. 1 in einer schematischen Darstellung,
Fig. 7 und 8 Rastelemente für eine Drosselklappenwelle gemäß Fig. 6,
Fig. 9 eine weitere Ausführungsform eines Zylinderkörpers einer Drosselklapenvorrichtung gemäß Fig. 1 in einer schematischen Schnittdarstellung,
Fig. Fig. 10 a einen Drosselklappenstutzen gemäß Fig. 9 mit einem qwergeteilten Innenzylinder in einer schematischen, auseinander gezogenen Darstellung,
10 b einen Drosselklappenstutzen gemäß Fig. 9 mit einem längsgeteilten Innenzylinder in einer schematischen, auseinander gezogenen Darstellung,
Fig. 11 a einen Drosselklappenstutzen einer Drosselklappenvorrichtung gemäß Fig. 1 bis 9 mit einem angeformten Gehäuseunterteil und einer Mess- und Steuereinheit in einer schematischen Darstellung,
Fig. 11b einen Drosselklappenstutzen einer Drosselklappenvorrichtung gemäß Fig. 11 a in einer schematischen, auseinander gezogenen Darstellung,
Fig. 12 bis 19 eine erste Ausführungsform eines Elements nach Bearbeitungsschritten in einer schematischen, perspektivischen Darstellung und
Fig. 20 bis 22 eine zweite Ausführungsform eines Elements nach Bearbeitungsschritten in einer schematischen, geschnittenen Darstellung.

Eine Drosselklappenvorrichtung ist im Motorraum Temperaturschwankungen, insbesondere Hitze, Kraftstoffgemischen und mechanischen Belastungen ausgesetzt. Für derartige Beanspruchungen ist die nachfolgend beschriebene Drosselklappenvorrichtung ausgerüstet und konzipiert.

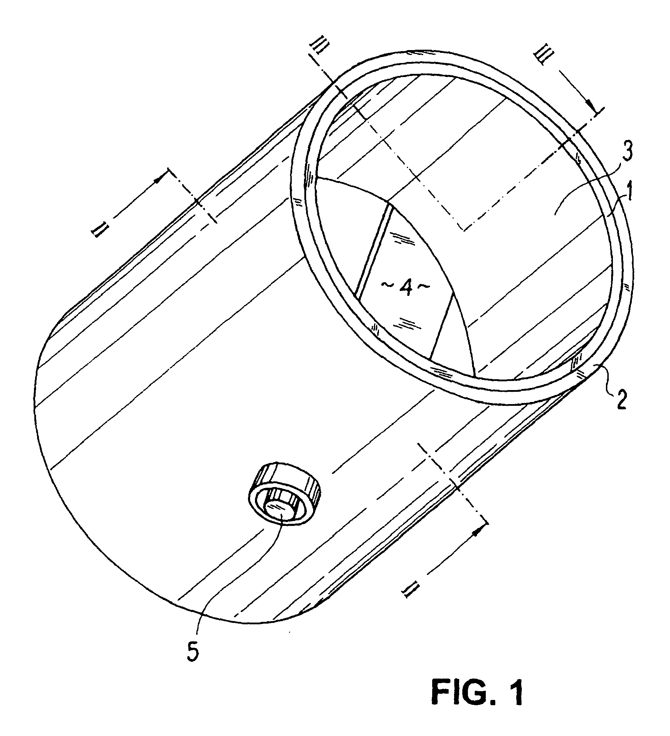

In den Figuren 1 bis 4 ist ein Hohlzylinder 100 dargestellt, der das Ausgangselement für eine Drosselklappenvorrichtung gemäß Erfindung darstellt. Der Hohlzylinder 100 weist einen Innenzylinder 1 aus einem Duroplasten auf und ist von einem Außenzylinder 2 aus einem Thermoplasten umgeben. Als Duroplast wird ein warmgehärtetes Epoxidharz mit hoher Wärmebeständigkeit und mit 25 Gew.-% Glasfaserfüllung verwendet. Auch andere Duroplasten, insbesondere andere Epoxydharze, können verwendet werden. Im Allgemeinen sind Duroplaste Kunststoffe, die sehr stabil, nach dem Formen verzugsarm, aber auch schlagempfindlich sind. Bis zur Ausformung sind lange Vernetzungszeiten notwendig. Zunächst werden Innenzylinder 1 als Formmassen im Press-, Spritzpress- oder Spritzgießverfahren mit der erforderlichen Wandstärke hergestellt und, falls erforderlich, nachbearbeitet.

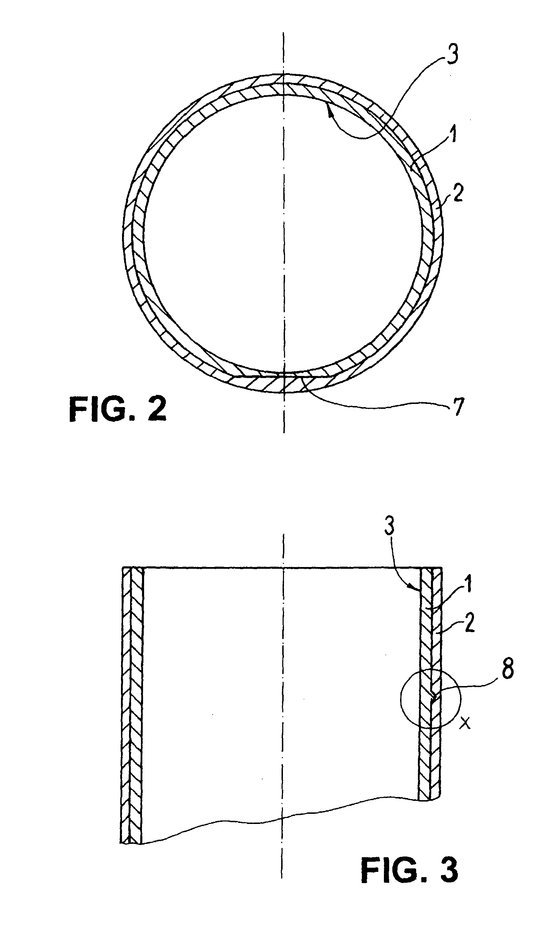

Um ein Festfressen der Drosselklappe 4 zu verhindern, ist die Innenwandung des Innenzylinders 11, wie Fig. 2 zeigt, mit einer Beschichtung 3 aus Teflon versehen. Auch können reibungsmindernde Füllstoffe dem Duroplast des Innenkörpers zugesetzt werden.

Der Außenzylinder 2 ist aus einem Thermoplast hergestellt und damit relativ gegenüber dem Innenzylinder 1 elastischer eingestellt. Er schützt den empfindlichen Innenkörper vor Beschädigungen. Der Außenzylinder 2 aus Thermoplast wird durch ein Umspritzverfahren, wie es an sich bekannt ist, um den Innenzylinder 1 herumgelegt. Hohlkörper aus Thermoplast können prinzipiell mit einem Spritzverfahren oder anderen, an sich bekannten Verfahren hergestellt werden.

Aus der Gruppe der technischen Thermoplaste haben sich Polyamide aufgrund ihrer guten Bearbeitungseigenschaften, ihrer hohen Wärmeformbeständigkeit und ihres hohen Glanzes zahlreiche Anwender erschlossen. Verbundmaterialien aus organischen Polymeren wie Polyamiden mit plättchenförmigen, aus Nanowerkstoffen bestehenden ("nanoskaligen") Füllstoffen, insbesondere schichtförmigen Silikaten (Phyllosilikaten) sind auch einsetzbar. Die thermoplastischen Materialien zeichnen sich durch eine hohe Steifigkeit aus. Neben einer Verbesserung der Steifigkeit nimmt die Zähigkeit durch den Zusatz der Phyllosilikate ab. Neben Polyamiden (PA) sind als Kunststoffe geeignet PBTB (Polybutylenterephtalat), PPS (Polyphenylensulfid), POM (Polyoxymethylen), aliphatische Polyketone, PVDF, PE (Polyethylen), z. B. HDPE (High Density Polyethylen), PP (Polypropylen), TEEE, TPE, PPA, PEEK (Polyetheretherketon), gehören.

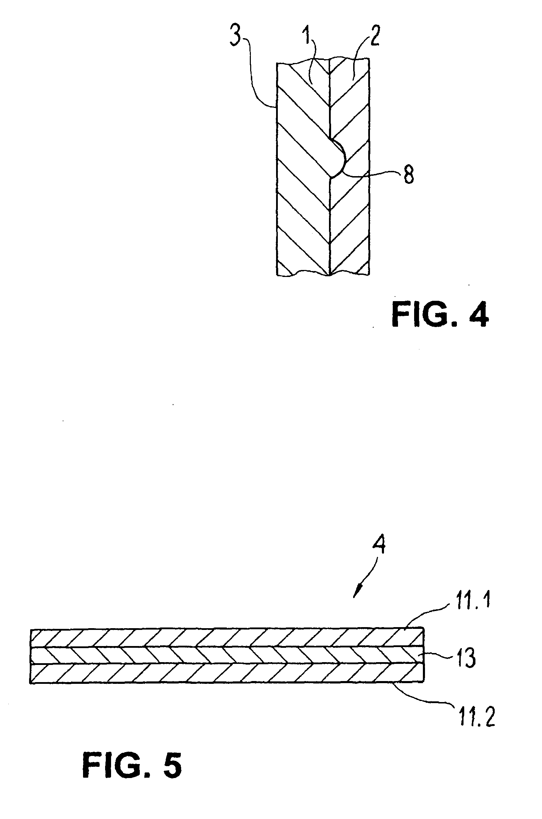

Innen- und Außenzylinder 1 und 2 werden mechanisch gegeneinander gesichert. So enthält der Innenzylinder 1 einen wenigstens teilweise durchgehenden Abflachungsabschnitt 7. Dieser Abschnitt verhindert ein Verdrehen des Innenzylinders 1 im Außenzylinder 2, wie Figur 2 zeigt. Um ein Verrutschen des Innenzylinders im Außenzylinder zu vermeiden, ist der Innenzylinder 1 mit einem wenigstens teilweise umlaufenden Rippenelement 8 versehen, wie die Figuren 3 und 4 zeigen.

Der entsprechend bearbeitete Hohlzylinder 100 bildet einen Drosselklappenstutzen, in dessen Inneren eine Drosselkappe 4 angeordnet ist, die zusammen mit einer Drosselklappenwelle 5 innerhalb des Drosselklappenstutzens drehbar angeordnet ist. Als Material für die Drosselklappe 4 werden ebenfalls Kunststoffe aus Duro- und Thermoplasten als Hauptbaustoffe gewählt. Wie Fig. 5 zeigt, ist bei der Drosselklappe 4 ein Duroplast-Mittelkörper 13 sandwichförmig von einem Thermoplast-Innen- und Außenzylinder 11, 12 eingefasst.

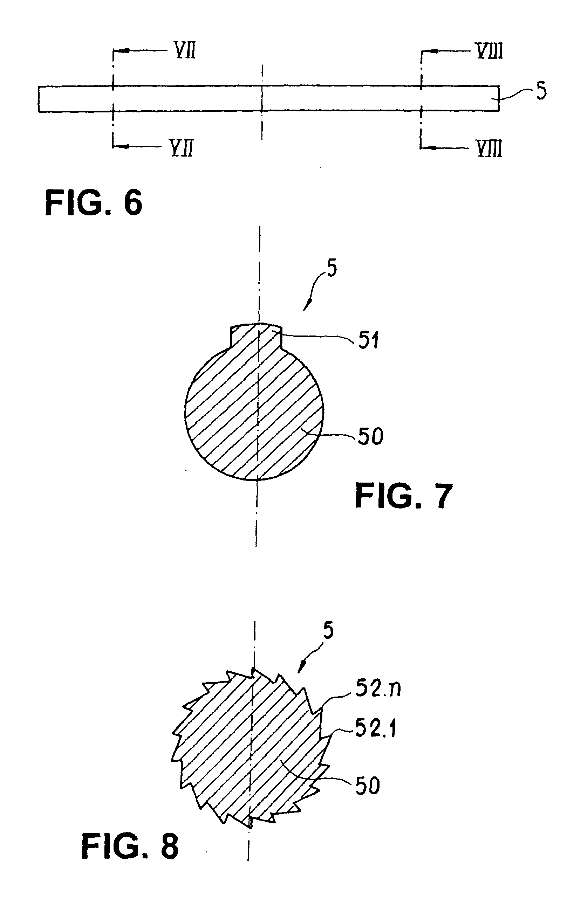

Die Drosselklappenwelle 5 gemäß Fig. 6 weist Rastelemente auf. In Fig. 7 ist an einen Wellenkörper 50 der Drosselklappenwelle ein Rastköper 51 angeformt. Gemäß Fig. 8 sind an dem Wellenkörper 50 Zahnelemente 52.1, ..., 52.n angeformt. Wird nun die Drosselklappenwelle 5 in die Drosselklappe 4 geschoben, sorgen die Rastelemente für ein kraftschlüssiges Festlegen. Drehbewegungen, die von einem Drosselklappenverstellmotor 45 abgegeben werden, werden direkt in eine Verstellung der Drosselklappe 4 umgesetzt.

Mit Hilfe einer Laserschweißverbindung oder mit Hilfe eines Umspritzverfahrens können Drosselklappenwelle 5 und Drosselklappe 4 miteinander verbunden bzw. einstückig hergestellt werden.

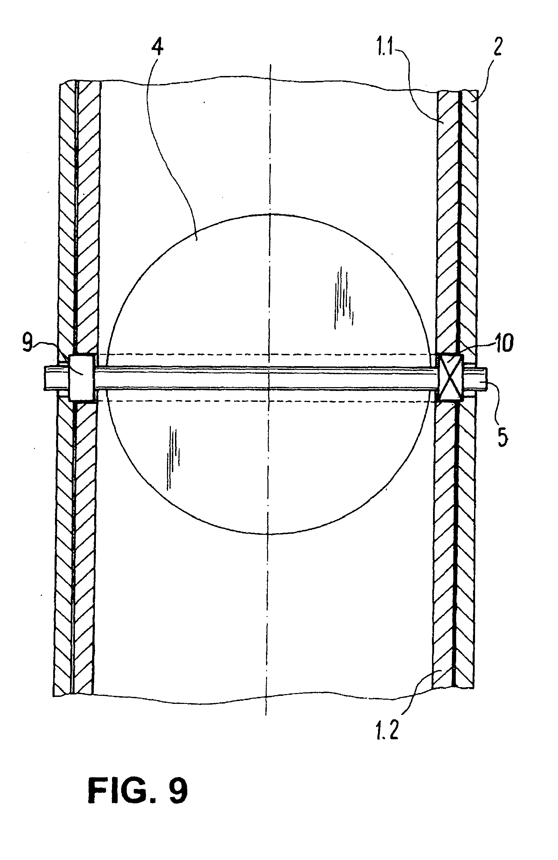

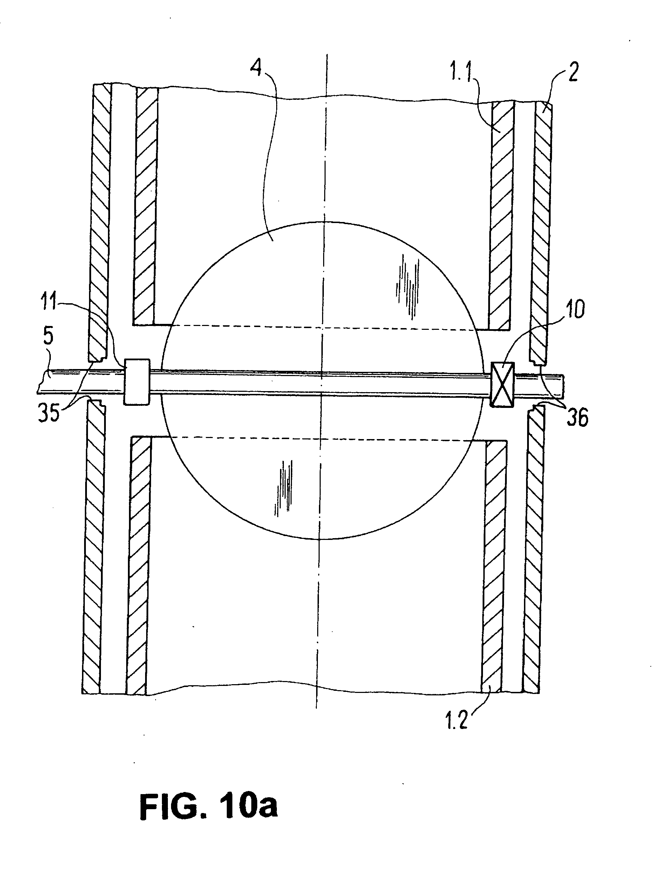

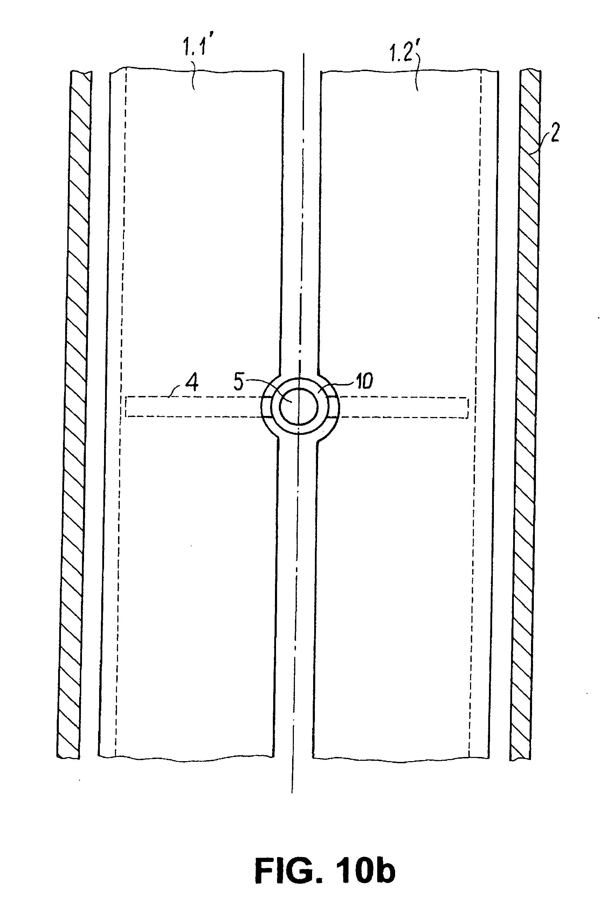

In den Fig. 9, 10 a und 10 b sind weitere Ausführungsformen eines Drosselklappenstutzens dargestellt. Der Innenzylinder 1 besteht hierbei in einen oberen und einen unteren Teilzylinder 1.1, 1.2 bzw linken und rechten Teilzylinder 1.1', 1.2'.
Beide Teilzylinder 1.1, 1.2 bzw. 1.1', 1.2' können jeweils wenigstens einen Abflachungsabschnitt bzw. wenigstens einen Rippenkörper aufweisen.
Die Teilung des Innenzylinders in den oberen Teilzylinder 1.1 und den unteren Teilzylinder 1.2 erfolgt, wie Fig. 10 a zeigt, in Höhe der Drosselklappenwelle 5. Bei einer Formung beider Teilzylinder 1.1, 1.2 werden Teilausnehmungen für ein Gleit- und/oder Kugellager für die Drosselklappenwelle 5 mit eingeformt. Stehen beide Teilköper 1.1, 1.2 zur Verfügung, wird die Drosselklappenwelle 5 mit den Lagern zwischen ihnen eingesetzt und anschließend beide Teilkörper verbunden und dann ein Außenzylinder aus Thermoplast herumgespritzt. Beim Formen des Außenzylinders 2 werden Lagereinfassungsbereiche 35, 36 mit geformt. Der Außenzylinder hält beide Teilzylinder 1.1, 1.2 abdichtend zusammen. Die Lagereinfassungsbereiche fixieren beide Lager und positionieren die Drosselklappenwelle 5. Die Teilung des Innenzylinders hingegen in den linken Teilzylinder 1.1' und den rechten Teilzylinder 1.2' erfolgt, gemäß Fig. 10a, in der Ebene der Drosselklappenwelle 5 als zwei Halbschalen. Bei einer Formung beider Teilzylinder 1.1', 1.2' werden auch hier die Teilausnehmungen für ein Gleit- und/oder Kugellager für die Drosselklappenwelle 5 mit eingeformt. Sind beide Teilköper 1.1', 1.2 geformt, wird die Drosselklappenwelle 5 mit den Lagern zwischen ihnen eingesetzt und anschließend beide Teilkörper verbunden und dann der Außenzylinder 2 aus Thermoplast herumgespritzt. Beim Formen des Außenzylinders 2 werden hier gleichfalls Lagereinfassungsbereiche 35, 36 mit geformt. Der Außenzylinder hält beide Teilzylinder 1.1', 1.2' abdichtend zusammen. Die Lagereinfassungsbereiche fixieren dann beide Lager und positionieren die Drosselklappenwelle 5.

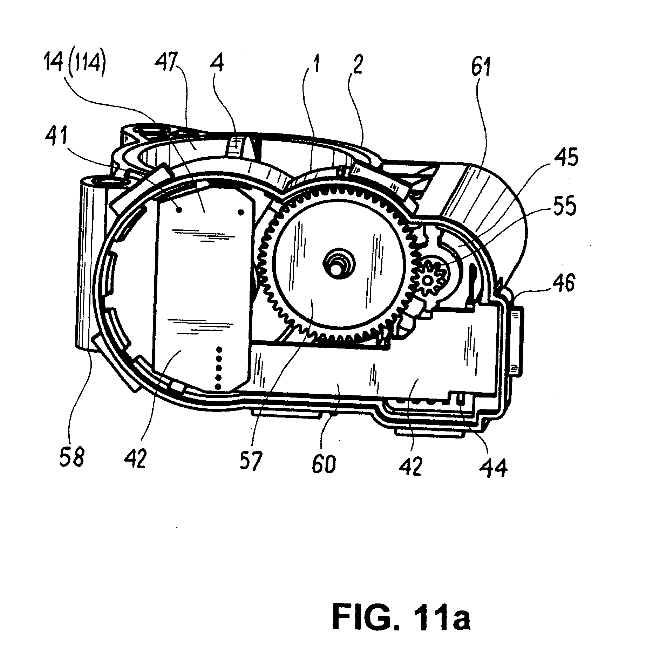

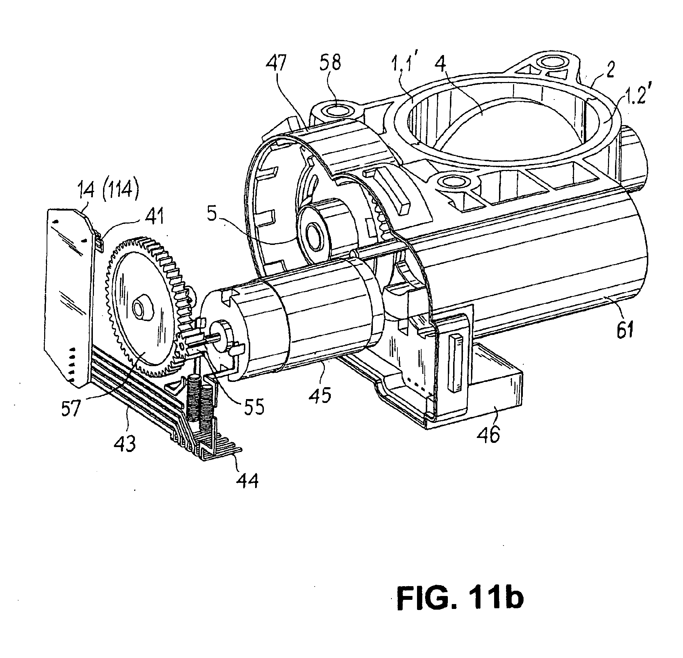

An den Außenzylinder 2 wird, wie die Fig. 11 a und 11 b zeigen, ein Unterteil eines Gehäuses 47 angeformt. Im Gehäuse 47 ist eine Mess- und Verstelleinrichtung untergebracht, umfassend eine Sensoreinheit 14, 41, 114 und eine Ausgangseinheit 44, 45, die durch ein Verbindungsgitterelement 42 verbunden sind. Das Verbindungsgitterelement 42 besteht aus mehreren Gitterschienen 43. Die Zahl der Gitterschienen 43 bestimmt sich aus der Vielzahl notwendiger Verbindungen. Die Gitterschienen sind wenigstens teilweise in einen Kunststoff, der vorzugsweise Thermoplast ist, eingeformt (vgl. Fig. 11 a). Um die durch die Temperaturänderungen bedingten Materialausdehnungen kompensieren zu können, kann das Verbindungsgitterelement 42 einen Dehnungsbogen aufweisen.

Die Ausgangseinheit besteht, wie insbesondere Fig. 11b zeigt, aus einem Steckerelement 44 und dem bereits erwähnten Drosselklappenverstellmotor 45. Die Steckerkontakte des Steckerelements 44 sind von einem Steckergehäuse 46 umgeben. Der Drosselklappenmotor 46 ist von einem Motorgehäuse 61 umgeben. Zwischen der Drosselklappenwelle 5 und dem Drosselklappenmotor 46 befindet sich ein Getriebe 55, 57, dessen kleines Zahnrad 55 am Motor 46 angeordnet und dessen großes Zahnrad 57 mit der Welle 5 in Verbindung steht.

Die Sensoreinheit umfasst eine Sensoreinheit 41 und eine Modul- oder Doppelmoduleinheit 14, 114.
In den Fig. 11 a und 11 b ist als Sensoreinheit ein induktiver Sensor gezeigt, der nach dem Sensopad-Prinzip arbeitet. An die Stelle des induktiven Sensors können auch andere Sensorelemente treten. Das Sensorelement 41 umfaßt eine Modul- bzw. Doppelmoduleinheit.

Der Vorteil der beschriebenen Mess- und Verstelleinrichtung besteht insbesondere darin, dass deren Teile vormontiert in das Unterteil des Gehäuses 47 eingesetzt werden können. Das Steckerelement 44 bzw. der Motor 45 werden in die entsprechenden Gehäuse 46, 61 eingesetzt. Anschließend werden sie mit Hilfe eines Befestigungselements fixiert. Danach wird ein Deckel auf das Gehäuse 47 aufgesetzt und mit Hilfe eines Haltestiftes oder einer Klemme festgehalten. Ein Maschinenelement 58 kann für eine Halterung der gesamten Drosselklappenvorrichtung verwendet werden.

Konzipierung und Realisierung der Moduleinheit 14 bzw. Doppelmoduleinheit 114 werden durch die Zweckmäßigkeit bestimmt.

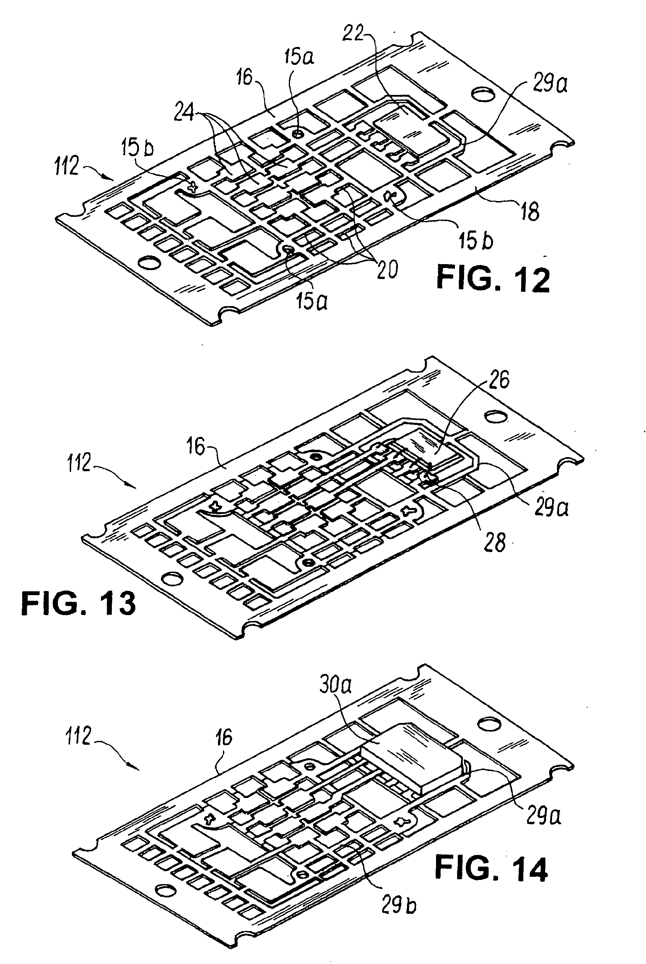

Aus einem dünnen Blechstreifen mit einer Stärke zwischen 0,1 bis 1,0 mm, vorzugsweise 0,18 bis 0,2 mm werden nacheinander, wie insbesondere Fig. 12 zeigt, Gitter 16 für Baueinheiten 112 herausgestanzt. Der Blechstreifen besteht aus Kupfer, kupferhaltigen Legierungen, Neusilber, Messing oder Bronze.

Jedes Stanzgitter 16 weist einen Flächenbereich 22, eine Vielzahl von Leitungssträngen 20 und Kontaktbereiche 24 auf, die von einem umlaufenden Rahmen 18 umgeben sind. Der Flächenbereich, auch Diepad genannt, wird wenigstens teilweise von einem Rahmen 29a, auch Danbar genannt, eingefasst. Für die spätere Positionierung und Fixierung sind Positionslöcher 15a bzw. Befestigungsöffnungen 15b vorgesehen. Weiterhin sind Fang- und/oder Zentrierlöcher eingestanzt.

Danach wird, wie Fig. 13 zeigt, auf den Flächenbereich 22 eine integrierte Schaltung 26 aufgebracht. Die integrierte Schaltung enthält hier das Hallelement oder einen anderen Sensor und die entsprechende Zentralprozessoreinheit und ist hier als ASIC (Application Specific Integrated Circuit) realisiert. Mit Hilfe von Bonddrähten 28 wird der ASIC 26 mit den Leitungssträngen vor dem Flächenbereich 22 verbunden.

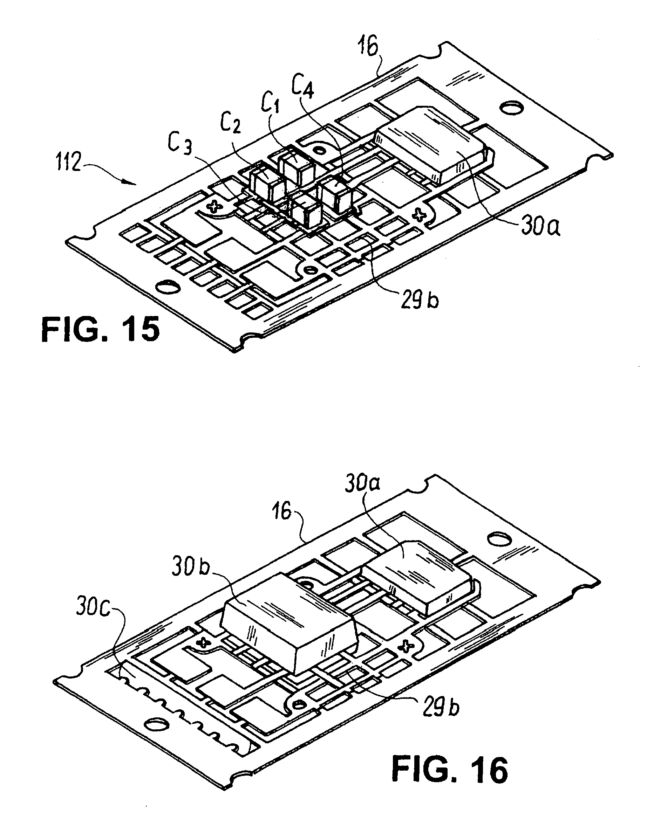

Ein Spritzkörper 30a aus Duroplast, hier Epoxidharz, umfasst, wie Fig. 14 zeigt, das ASIC 26, die Bonddrähte 28 und die Leitungsstränge 20 wenigstens teilweise. Der Rahmen 29a dichtet beim Spritzen die Spritzgussform ab und verhindert, dass Kunststoff zwischen den Leitungssträngen entweichen kann. Anschließend werden (vgl. Fig. 15) auf die Kontaktbereiche 24 diskrete Bauelemente C1, C2, C3, C4 gesetzt. Sie dienen als Beschaltung des ASICs 26. Die Bauelemente, realisiert als Kondensatoren C1, C2, C3, C4 werden mit einem Spritzkörper 30b gekapselt, der ebenfalls aus Duroplast ist (16). Ein Rahmen 29b spielt hier die Rolle wie der Rahmen 29a bei der Formung des Spritzkörpers 30a. Die Formung aller Spritzkörper kann gleichzeitig erfolgen.

Mit dem Spritzkörper 30b wird ein Haltekörper 30c mit gespritzt, der eine Leitungsstruktur aus mehreren parallelen Stegen einbettet. Dieser Umspritzung kommt beim Prüfen der fast fertigen Moduleinheit eine besondere Aufgabe zu.

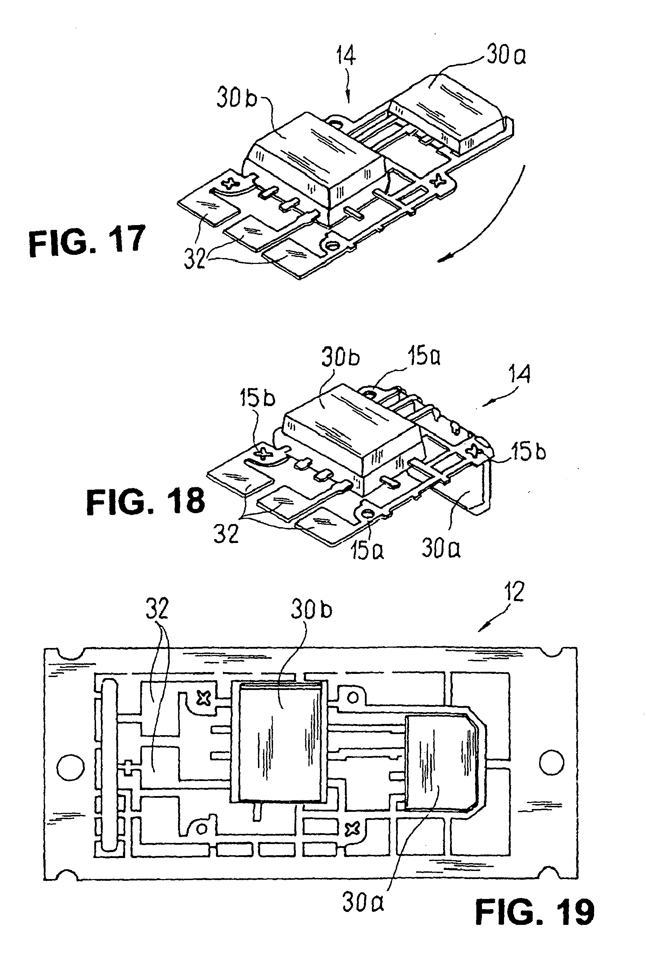

Wie Fig. 19 zeigt, werden die Kurzschlüsse aller Nicht-Massekontakte entfernt, wobei die Sensoreinheit 14 noch nicht vom Stanzgitter getrennt ist. Die Sensoreinheit 14 umfasst drei Kontaktflächen 32, von denen zwei wie auch die die zugehörigen Leitungsstege elektrisch gegenüber dem Stanzgitter 16 isoliert sind. Der Massekontakt und die zugehörigen Leiterstege sind weiterhin mit dem Stanzgitter 16 verbunden. Eine mechanische Verbindung ist zusätzlich über den Haltekörper 30c weiterhin geschaffen. Hierfür sind die parallelen Stege, die im Haltekörper eingebettet sind, abwechselnd auf Seiten des Stanzgitters 16 und auf Seiten der mit den Kontaktflächen 32 verbundenen Teile des Stanzgitters 16 aufgetrennt. Im Ergebnis gibt es keine elektrische Verbindung mehr zwischen dem Stanzgitter 16 und den beiden Kontaktflächen 32, die nicht als Massekontakt dienen.

Ist die Prüfung abgeschlossen, werden alle Rahmen 18, 29a und 29b und verbliebene Brücken zwischen den Leitungssträngen 20 durch Stanzen entfernt. Durch diesen Stanzvorgang wird die elektrische Schaltung endgültig hergestellt. Die Haltefunktionen von Anschlüssen und Leitungsverbindungen werden von den Spritzkörpern 30a und 30b übernommen. Die fertige Moduleinheit 14, bestehend aus dem ASIC bzw. einer anderen integrierten Schaltung und den Bauelementen für Schutzbeschaltung und dgl. stehen dann, wie Fig. 17 zeigt, mit den entsprechen Gehäusen zur Verfügung.

Soll der Modul nur über ein Gehäuse verfügen, können ASIC mit Bonddrähten und Bauelemente mit jeweils einem Arbeitsgehäuse vorgekapselt werden. Anschließend wird der beschriebene Schaltungsendschnitt vollzogen und das ganze Gebilde mit einem einzigen Spritzgehäuse umgeben.

Die Moduleinheit 14 wird gemäß Fig. 18 in einem letzten Schritt durch ein Abbiegen des Spritzkörpers 30a mit dem ASIC 26 bearbeitet. Die dünnen verbleibenden Leitungsstränge 20 des dünnen Stanzgitters 16 erlauben einen problemlosen Biegevorgang. Die Moduleinheit 14 hat nun nur noch eine Länge von ca. 20 bis 40 mm und lässt sich am Verbindungsgitterelement 42 bei gleichzeitiger funktioneller Positionierung befestigen.

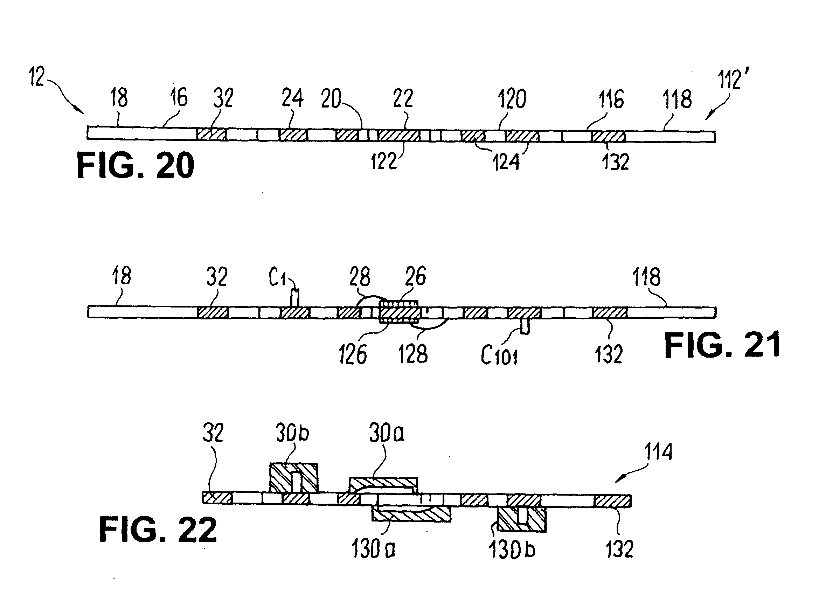

In den Fig. 20 bis 22 sind die Bearbeitungsschritte für eine leistungsfähigere Sensoreinheit (Doppelmoduleinheit) 114 gezeigt.
Aus dem dünnen Blechstreifen mit einer Stärke zwischen 0,1 bis 1,0 mm, vorzugsweise 0,18 bis 0,2 mm werden nacheinander, wie insbesondere Fig. 20 zeigt, Gitter 116 für Baueinheiten 112' herausgestanzt. Der Blechstreifen besteht auch hier aus Kupfer, eine kupferhaltige Legierung, Neusilber, Messing oder Bronze.

Jedes Stanzgitter 116 weist Flächenbereiche 22, 122, eine Vielzahl von Leitungssträngen 20, 120 und Kontaktbereiche 24, 124 auf, die von umlaufenden Rahmen 18, 118 umgeben sind. Die Flächenbereiche werden wenigstens teilweise von Rahmen, auch Danbar genannt, eingefasst. Beide Flächenbereiche gehören zu einer leitfähigen Platte. Für die spätere Positionierung und Fixierung sind Positionslöcher 15a bzw. Befestigungsöffnungen 15b.oder dgl. vorgesehen. Das Stanzgitter 116 besteht im Vergleich zu Fig. 12 aus dem bereits beschriebenen Stanzgitter 16, an das sich im Wesentlichen vom Flächenbereich 22 an eine im Wesentlichen gleiche Konfiguration anschließt.

Danach wird, wie Fig. 21 zeigt, auf den Flächenbereich 22 eine integrierte Schaltung 26 aufgebracht. Die integrierte Schaltung enthält hier das Sensorelement und die entsprechende Prozessoreinheit und ist als ASIC realisiert. Mit Hilfe von Bonddrähten 28 wird das ASIC 26 mit den Leitungssträngen vor dem Flächenbereich 22 verbunden. Auf der Gegenseite wird auf den Flächenbereich 122 eine weitere integrierte Schaltung 126 aufgeklebt. Bonddrähte 128 verbinden das ASIC 126 mit den Leitungssträngen 120. Anschließend werden auf die Kontaktbereiche 24 diskrete Bauelemente C1, C2, C3, C4 gesetzt und auf die Kontaktbereiche 124 diskrete Bauelemente C101 gesetzt. Die Bauelemente, z.B. Kondensatoren, C1, ... C4 dienen der Beschaltung des ASICs 26 und die Kondensatoren C101, ... der Beschaltung des ASICs 126. Die erwähnten Fang- und Zentrierlöcher sichern eine lagegerechte beiderseitige Beschaltung.

Ein Spritzkörper 30a aus Duroplast, insbesondere Epoxidharz umfasst, wie Fig. 22 zeigt, das ASIC 26, die Bonddrähte 28 und die Leitungsstränge 20 wenigstens teilweise. Der Rahmen 29a dichtet beim Spritzen die Spritzgussform ab und verhindert, dass Kunststoff zwischen den Leitungssträngen entweichen kann. In gleicher Art und Weise werden das ASIC 126, die Bonddrähte 128 und die Leitungsstränge 120 auf der gegenüberliegenden Seite mit einem Spritzkörper 130a eingefasst.

Die Bauelemente C1, C2, C3, C4 werden mit einem Spritzkörper 30b und die Bauelemente C101, ... mit einem Spritzkörper 130b gekapselt, die ebenfalls aus Duroplast sind. Rahmen 29b, ... spielen hier die gleiche Rolle wie die Rahmen 29a, ... bei der Formung des Spritzkörpers 30a, 130a.

Mit den Spritzkörpern 30a, 30b, 130a, 130b, die zu beiden Seiten Leitungsstrukturen aus mehreren parallelen Stegen einbetten, wird ein Haltekörper mit gespritzt. Diesen Umspritzungen kommen beim Prüfen der fast fertigen Doppelmoduleinheit ebenfalls besondere Aufgaben zu.

Letztendlich werden alle Rahmen 18, 29a und 29b sowie 118 und verbliebene Brücken zwischen den Leitungssträngen 20, 120 durch Stanzen entfernt. Durch diesen Stanzvorgang wird die elektrische Schaltung endgültig hergestellt. Die Haltefunktionen von Anschlüssen und Leitungsverbindungen werden von den Spritzkörpern 30a und 30b sowie 130a und 130b übernommen.
Die fertige Doppelmoduleinheit 114, bestehend aus ein oder zwei ASICs bzw. anderen integrierten Schaltungen und den Bauelementen für die Schutzbeschaltung und dgl., steht dann mit den entsprechen Gehäusen zur Verfügung.

Zusammenfassend ist festzustellen, dass für eine kostengünstige und genaue Herstellung einer Drosselklappenvorrichtung nur zwei Hauptmaterialien zum Einsatz kommen, nämlich
- Kunststoffe und
- dünne Blechstreifen.
Hierbei lassen sich aus Duroplast und Thermoplast Drosselklappenstutzen in Form von Zylinderkörpern formen, die sich leichter und passgenauer herstellen lassen und die höhere Gebrauchswerteigenschaften haben. Es lassen sich Drosselklappenkörper formen, die lagegenauer im Drosselklappenstutzen zu verstellen sind. Eine PTFE-Beschichtung lässt sich aufbringen, die ein einwandfreies Bewegen der neuen Drosselklappe im neuen Drosselklappenstutzen sichert.

Hinzu kommen gestanzte Blechstreifen-Stanzgitter (Leadframes), die sich mit ASICs, Bauelementen und dgl. zu einer Modul- bzw. Doppelmoduleinheit bestücken lassen, wobei ein Verbindungsgitterelement eine Sensoreinheit mit einer Modul- bzw. Doppelmoduleinheit mit einer Ausgangseinheit montage- und einbaugerecht verbindet.

## Patentansprüche

1. Drosselklappenvorrichtung, bestehend aus wenigstens einem Drosselklappenstutzen (1, 2, 3), einer Drosselklappe (4) und einer Drosselklappenwelle (5), mit der die Drosselklappe (4) verstellbar im Drosselklappenstutzen (1, 2, 3) angeordnet ist, **dadurch gekennzeichnet, dass** der Drosselklappenstutzen aus einem Innenzylinder (1) aus einem harten, glatten, Werkstoff besteht, um den wenigstens teilweise ein Außenzylinder (2) aus einem Thermoplasten geformt ist.

2. Drosselklappenvorrichtung nach Anspruch 1, **dadurch gekennzeichnet, dass** der Werkstoff ein nicht-metallischer Werkstoff ist, ausgewählt aus einem Duroplasten oder einem keramischen Werkstoff.

3. Drosselklappenvorrichtung nach Anspruch 1, **dadurch gekennzeichnet, dass** der Werkstoff ein metallischer Werkstoff ist, ausgewählt ein gezogenes Aluminium, Magenesium oder ein fließgepreßtes Material.

4. Drosselklappenvorrichtung nach Anspruch 1 oder 2 oder 1 oder 3, **dadurch gekennzeichnet, dass** der Thermoplast ausgewählt ist aus der Gruppe PA (Polyamide), PBTB (Polybutylenterephtalat), PPS (Polyphenylensulfid), POM (Polyoxymethylen), aliphatische Polyketone, PVDF, Polyolefine, wie PE (Polyethylen), HDPE (High Density Polyethylen) oder PP (Polypropylen) sowie deren Mischpolymerisate, TEEE, TPE, PPA, PEEK (Polyetheretherketon).

5. Drosselklappenvorrichtung nach einem der vorhergehenden Ansprüche, **dadurch gekennzeichnet, dass** die zylindrischen Hohlkörper (1; 2) als gezogene Präzisionsrohre hergestellt sind.

6. Drosselklappenvorrichtung nach einem der vorhergehenden Ansprüche, **dadurch gekennzeichnet, dass** die Drosselklappe (4) aus einem Duroplast-Mittelkörperelement (13) besteht, das wenigstens teilweise von einem Thermoplast-Einfassungsköper (11, 12) umgeben ist.

7. Vorrichtung nach einem der vorhergehenden Ansprüche, **dadurch gekennzeichnet, dass** die Drosselklappe (4) aus einem Duroplast-Mittelkörperelement (13) besteht, das allseitig wenigstens teilweise von einem Thermoplast-Einfassungsköper (11, 12) umgeben ist.

8. Vorrichtung nach einem der vorhergehenden Ansprüche, **dadurch gekennzeichnet, dass** der Innenzylinder (1) wenigstens teilweise mit einem Abflachungsabschnitt (7) versehen ist.

9. Vorrichtung nach einem der vorhergehenden Ansprüche, **dadurch gekennzeichnet, dass** der Innenzylinder (1) wenigstens teilweise von einem Rippenabschnitt (8) umgeben ist.

10. Vorrichtung nach einem der vorhergehenden Ansprüche, **dadurch gekennzeichnet, dass** der Innenzylinder (1) wenigstens teilweise mit einer Innenbeschichtung (3) versehen ist.

11. Vorrichtung nach einem der vorhergehenden Ansprüche, **dadurch gekennzeichnet, dass** der Innenzylinder (1) in Höhe der Drosselklappenwelle (5) geteilt ist.

12. Vorrichtung nach einem der vorhergehenden Ansprüche, **dadurch gekennzeichnet, dass** der Innenzylinder (1) in einen oberen und einen unteren Teilzylinder (1.1, 1.2) geteilt ist.

13. Vorrichtung nach einem der vorhergehenden Ansprüche, **dadurch gekennzeichnet, dass** der Innenzylinder (1) in einen linken und rechten Teilzylinder (1.1', 1.2') geteilt ist.

14. Vorrichtung nach einem der vorhergehenden Ansprüche, **dadurch gekennzeichnet, dass** die Innenbeschichtung (3) wenigstens teilweise aus PTFE (Handelsname Teflon) besteht.

15. Vorrichtung nach einem der vorhergehenden Ansprüche, **dadurch gekennzeichnet, dass** die Drosselklappenwelle (5) wenigstens ein Rastelement (51; 52.1, ..., 52.n) aufweist, durch das die Drosselklappenwelle (5) mit der Drosselklappe (4) zu verbinden ist.

16. Vorrichtung nach Anspruch 10, **dadurch gekennzeichnet, dass** das Rastelement ein Rastkörper (51) ist.

17. Vorrichtung nach Anspruch 10, **dadurch gekennzeichnet, dass** die Rastelemente Zahnelemente (52.1, ..., 52.n) sind.

18. Vorrichtung nach einem der vorhergehenden Ansprüche, **dadurch gekennzeichnet, dass** auf dem Mittelkörperelement (13) der Drosselklappe (4) ein Thermoplast-Innenkörper (11) als Thermoplast-Einfassungskörper angeordnet ist.

19. Vorrichtung nach einem der vorhergehenden Ansprüche, **dadurch gekennzeichnet, dass** auf dem Mittelköperelement (13) der Drosselklappe (4) dem Thermoplast-Innenkörper (11) gegenüberliegend ein Thermoplast-Außenkörper (12) angeordnet ist.

20. Vorrichtung nach einem der vorhergehenden Ansprüche, **dadurch gekennzeichnet, dass** die Drosselklappenwelle (5) in Gleit- und/oder Kugellagern (9, 10) gelagert ist.

21. Vorrichtung nach einem der vorhergehenden Ansprüche, **dadurch gekennzeichnet, dass** verbunden mit dem Außenzylinderhohlkörper (2) aus Thermoplast ein Gehäuse (47) mit angeformt ist.

22. Vorrichtung nach einem der vorhergehenden Ansprüche, **dadurch gekennzeichnet, dass** im Gehäuse (47) eine Mess- und Verstelleinrichtung angeordnet ist, bei der eine Sensoreinheit (14, 41, 114) und eine Ausgangseinheit (44, 45) durch ein Verbindungsgitterelement (42) verbunden sind, das wenigstens eine Gitterschiene aufweist.

23. Vorrichtung nach einem der vorhergehenden Ansprüche, **dadurch gekennzeichnet, dass** die Sensoreinheit eine Moduleinheit (14) aufweist, bei der eine integrierte Schaltung (26) auf einem Flächenbereich (22) einer leitenden Platte angeordnet und durch einen Spritzkörper (30a) gekapselt ist, und bei der über Leitungsstränge die integrierte Schaltung (26) mit Bauelementen (C1, C2, C3, C4) verbunden ist, die durch einen weiteren Spritzkörper (3ob) gekapselt sind.

24. Vorrichtung nach einem der vorhergehenden Ansprüche, **dadurch gekennzeichnet, dass** die Sensoreinheit eine Doppelmoduleinheit (114) aufweist, bei der eine leitfähige Platte einen oberen und unteren Flächenbereich (22, 122) aufweist,
- wobei auf dem oberen Flächenbereich (22) eine erste integrierte Schaltung (26) angeordnet und durch einen ersten Spritzkörper (30a) gekapselt ist,
- wobei über erste Leitungsstränge (20) die erste integrierte Schaltung (26) mit ersten Bauelementen (C1, C2, C3, C4) verbunden ist, die durch einen zweiten Spritzkörper (30b) gekapselt sind,
- wobei auf dem unteren Flächenbereich (122) eine zweite integrierte Schaltung (126) angeordnet ist, die durch einen dritten Spritzkörper (130a) gekapselt ist, und
- wobei über zweite Leitungsstränge (120) die zweite integrierte Schaltung (126) mit zweiten Bauelementen (C101) verbunden ist, die durch einen vierten Spritzkörper (130b) gekapselt sind.

25. Vorrichtung nach einem der vorhergehenden Ansprüche, **dadurch gekennzeichnet, dass** der Innenzylinder (1) in einen oberen und einen unteren Teilzylinder (1.1, 1.2) geteilt ist.

26. Vorrichtung nach einem der vorhergehenden Ansprüche, **dadurch gekennzeichnet, dass** der Innenzylinder (1) in einen linken und einen rechten Teilzylinder (1.1', 1.2') geteilt ist.

27. Vorrichtung nach einem der vorhergehenden Ansprüche, **dadurch gekennzeichnet, dass** der Innenzylinder (1) im Bereich des Wellenelements (5) geteilt ist.

28. Vorrichtung nach einem der vorhergehenden Ansprüche, **dadurch gekennzeichnet, dass** die Gleit- und/oder Kugellager (9, 10) wenigstens teilweise durch Lagereinfassungsbereiche (35, 36) des Außenzylinder (2) aus Thermoplast eingefasst sind.

29. Verfahren zur Herstellung einer Drosselklappenvorrichtung mit wenigstens
- einem Drosselklappenstutzens (1, 1.1, 1.2, 1.1', 1.2' , 2),
- einer Drosselklappe (4) und
- einer Drosselklappenwelle (5), mit dem die Drosselklappe verstellbar im Doppelklappenstutzen (1,2) angeordnet ist, **gekennzeichnet durch** folgende Verfahrensschritte:
a) Formen eines Innenzylinders (1) mit wenigstens einem Abflachungsabschnitt (7) und wenigstens einem Rippenelement (8) aus einem harten, glatten, Werkstoff;
b) Einformen von Gleit- und/oder Kugellagern (9, 10) beim Formen des Innenzylinders (1);
c) Umspritzen des Innenzylinders (1) **durch** einen Außenzylinder (2) aus Thermoplast und wenigstens teilweises Einfassen der Gleit- und/oder Kugellager (9, 10) **durch** Lagereinfassungsbereiche 35, 36).

30. Verfahren zur Herstellung einer Drosselklappenvorrichtung mit wenigstens
- einem Drosselklappenstutzen (1.1, 1.2, 1.1, 1.2', 2),
- einer Drosselklappe (4) und
- einer Drosselklappenwelle (5), mit dem die Drosselklappe verstellbar im Drosselklappenstutzen (1.1, 1.2, 2) angeordnet ist, **gekennzeichnet durch** folgende Verfahrensschritte:
a) Formen von zwei Teil-Innenzylindern (1.1, 1.2; 1.1', 1.2') aus aus einem harten, glatten, Werkstoff mit wenigstens einem Abflachungsabschnitt (7) und wenigstens einem Rippenelement (8);
b) Aufstecken von Gleit- und/oder Kugellagern (9, 10) auf die Drosselklappenwelle (5);
c) Zusammensetzen der beiden Teil-Innenzylinder und Einfassen der Gleit- und/oder Kugellager **durch** beide Teil-Innenzylinder;
d) Umspritzen des oberen und unteren Teil-Innenzylinders **durch** einen Außenzylinder (2) aus Thermoplast und wenigstens teilweises Einfassen der Gleit- und/oder Kugellager (9, 10) **durch** Lagereinfassungsbereiche (35, 36).

31. Verfahren zur Herstellung einer Drosselklappenvorrichtung mit wenigstens
- einem Drosselklappenstutzen (1.1, 1.2, 1.1, 1.2', 2),
- einer Drosselklappe (4) und
- einer Drosselklappenwelle (5), mit dem die Drosselklappe verstellbar im Drosselklappenstutzen (1.1, 1.2, 2) angeordnet ist, **gekennzeichnet durch** eine Verwendung von Duroplast derart, dass
a) dass zwei Teil-Innenzylinder (1.1, 1.2; 1.1', 1.2') aus aus Duroplast mit wenigstens einem Abflachungsabschnitt (7) und wenigstens einem Rippenelement (8) geformt werden,
b) dass Gleit- und/oder Kugellager (9, 10) auf die Drosselklappenwelle (5) aufgesteckt werden,
c) dass die beiden Teil-Innenzylinder zusammen gesetzt und die Gleit- und/oder Kugellager der zwischen ihnen eingesetzten Drosselklappenwelle (5) **durch** beide Teil-Innenzylinder eingefasst werden,
d) dass die beiden Teil-Innenzylinder **durch** einen Außenzylinder (2) aus Thermoplast umspritzt und die Gleit- und/oder Kugellager (9, 10) **durch** Lagereinfassungsbereiche (35, 36) wenigstens teilweises eingefasst werden.

32. Verfahren nach einem der vorhergehenden Ansprüche, **dadurch gekennzeichnet, dass** beim Formen des Außenzylinderhohlkörpers (2) ein Gehäuseunterteil (49) mit angeformt wird.
